# FASCICULE DE BREVET EUROPEEN

(11) **EP 3 326 963 B1**
(45) Date de publication et mention de la délivrance du brevet: **01.01.2020**
(21) Numéro de dépôt: 16200182.0
(22) Date de dépôt: 23.11.2016
(51) Int. Cl.: B81C 1/00, G04B 17/04, G04B 31/02

(54) **LAME FLEXIBLE POUR L'HORLOGERIE ET PROCEDE DE FABRICATION**
FLEXIBLES BLATT FÜR UHRWERK UND HERSTELLUNGSVERFAHREN
FLEXIBLE BLADE FOR WATCHMAKING AND METHOD OF MANUFACTURING

(43) Date de publication de la demande: 30.05.2018
(73) Titulaire: The Swatch Group Research and Development Ltd, 2074 Marin (CH)
(72) Inventeur: Di Domenico, Gianni, 2000 Neuchâtel (CH); Favre, Jérôme, 2000 Neuchâtel (CH); Léchot, Dominique, 2722 Les Reussilles (CH); Hinaux, Baptiste, 1005 Lausanne (CH); Matthey, Olivier, 1422 Grandson (CH); Cusin, Pierre, 1423 Villars-Burquin (CH); Gandelhman, Alex, 2000 Neuchâtel (CH)
(74) Mandataire: Giraud, Eric

(56) Documents cités:
- WO-A1-2012/010408
- CH-A2- 707 554
- CH-A2- 709 291
- JP-A- 2016 133 494
- T. TAKANO ET AL: "Measurements of silicon dry-etching rates and profiles in MEMS foundries and their application to MEMS design software", SPIE - INTERNATIONAL SOCIETY FOR OPTICAL ENGINEERING. PROCEEDINGS, vol. 6800, 10 décembre 2007 (2007-12-10), page 68001X, XP055372524, US ISSN: 0277-786X, DOI: 10.1117/12.759374 ISBN: 978-1-5106-0753-8

## Description

### Domaine de l'invention

L'invention concerne un procédé de fabrication d'au moins une lame flexible droite pour l'horlogerie en matériau micro-usinable, comportant une surface supérieure et une surface inférieure parallèles, comportant au moins les étapes consistant à :
- se munir d'au moins une tranche de substrat en matériau micro-usinable, comportant une face supérieure et une face inférieure parallèles ;
- constituer une plaque d'épaisseur requise par une dite tranche de substrat unique ou par solidarisation d'une pluralité de dites tranches de substrat ;
- apposer un premier masque supérieur comportant au moins une fenêtre supérieure sur la face supérieure de ladite plaque, et un deuxième masque inférieur comportant au moins une fenêtre inférieure sur la face inférieure de ladite plaque ;
- graver ladite plaque, à une profondeur de gravure inférieure à ladite épaisseur requise, depuis un côté supérieur au niveau de chaque dite fenêtre supérieure, en réalisant, connexe à ladite surface supérieure, une première surface périphérique de chant en dépouille par rapport à ladite surface supérieure, sur une première hauteur,
- et depuis un côté inférieur au niveau de chaque dite fenêtre inférieure, en réalisant, distante de ladite surface supérieure et connexe à ladite surface inférieure, une deuxième surface périphérique de chant en contre-dépouille par rapport à ladite première surface périphérique de chant,
- retirer ledit premier masque supérieur et ledit deuxième masque inférieur. Le procédé est caractérisé en ce que ladite première surface périphérique de chant et ladite deuxième surface périphérique de chant sont symétriques par rapport à un plan médian à égale distance de ladite surface supérieure et de ladite surface inférieure, et en ce que ledit premier masque supérieur et ledit deuxième masque inférieur sont de géométrie identique et disposés en symétrie par rapport à un plan médian situé à mi-épaisseur de ladite plaque, et en ce que la somme desdites profondeurs de gravure est supérieure ou égale à l'épaisseur de ladite plaque, de façon à délimiter au moins une lame flexible droite dont la hauteur est égale à l'épaisseur de ladite plaque, dont la largeur est définie par le profil dudit premier masque supérieur et dudit deuxième masque inférieur, et dont les bords sont bruts de gravure. L'invention concerne encore une lame flexible droite pour l'horlogerie, en matériau micro-usinable, comportant une surface supérieure et une surface inférieure parallèles, et, connexe à ladite surface supérieure, une première surface périphérique de chant en dépouille par rapport à ladite surface supérieure, sur une première hauteur, caractérisée en ce que ladite lame flexible comporte, distante de ladite surface supérieure et connexe à ladite surface inférieure, une deuxième surface périphérique de chant en contre-dépouille par rapport à ladite première surface périphérique de chant, en ce que ladite première surface périphérique de chant et ladite deuxième surface périphérique de chant sont symétriques par rapport à un plan médian à égale distance de ladite surface supérieure et de ladite surface inférieure, et en ce que, ou bien ladite surface supérieure et ladite surface inférieure appartiennent à une même couche unique de dit matériau micro-usinable, ou bien ladite surface supérieure et ladite surface inférieure appartiennent respectivement à une couche supérieure et à une couche inférieure qui sont deux couches différentes d'un même premier matériau micro-usinable entre lesquelles s'étend au moins une couche intermédiaire d'un deuxième matériau micro-usinable différent dudit premier matériau micro-usinable ou d'un oxyde dudit premier matériau micro-usinable.

L'invention concerne encore un pivot flexible comportant une pluralité de telles lames flexibles.

L'invention concerne encore un résonateur d'horlogerie comportant au moins un tel pivot flexible.

L'invention concerne encore un mouvement d'horlogerie comportant au moins un tel résonateur, ou/et au moins un pivot flexible.

L'invention concerne encore une montre comportant au moins un tel résonateur, ou/et au moins un tel pivot flexible.

L'invention concerne le domaine des mécanismes horlogers incorporant des lames flexibles élastiques, pour des fonctions de guidage ou/et de rappel élastique, et plus particulièrement des dispositifs de pivots flexibles, et de résonateurs.

### Arrière-plan de l'invention

Il est possible de réaliser un résonateur isochrone, pour l'horlogerie, indépendant des positions, et avec un très haut facteur de qualité, en combinant un pivot à lames flexibles avec un élément inertiel, par exemple un balancier.

Lorsqu'un tel pivot à lames flexibles est réalisé en silicium, leur rapport d'aspect est limité par les techniques de gravure.

L'utilisation d'un tel pivot à guidage flexible permet de remplacer le pivot classique, à contact, d'un balancier, ainsi que le ressort spiral de rappel élastique. Ceci à l'avantage de supprimer les frottements de pivots, ce qui permet d'augmenter considérablement le facteur de qualité du résonateur. Toutefois les pivots à guidage flexible sont connus pour :
- avoir un mouvement parasite de l'axe instantané de rotation ce qui rend la marche du résonateur sensible à sa position dans le champ de la gravité ;
- avoir une force de rappel élastique non-linéaire ce qui rend le résonateur anisochrone c'est-à-dire que la fréquence dépend de l'amplitude de l'oscillation ;
- avoir une faible excursion angulaire maximale (de l'ordre de 15 à 20 degrés) ;
- avoir une faible tenue aux chocs.

Le document EP 2911012 A1 au nom de CSEM décrit un tel pivot flexible, à lames croisées, en application du principe énoncé par W.H. Wittrick, Aeronautical quarterly Il (1951), où le point de croisement des lames est positionné au 1/8 (ou 7/8) de la longueur des lames ce qui permet de réduire notablement l'effet des positions.

La demande européenne EP14199039.0 au nom de The Swatch Group Research & Development Ltd décrit également un résonateur à deux lames croisées, de type pivot Wittrick, situées dans des plans parallèles et dont le croisement, en projection sur l'un de ces plans, correspond à l'axe de pivotement de l'élément inertiel. Ce résonateur comporte un angle particulier de 72° entre les deux lames, ce qui optimise la linéarité de la force de rappel élastique, et par conséquent rend le résonateur isochrone pour une gamme d'amplitude angulaire donnée, en supposant qu'il est réalisé dans un matériau parfaitement élastique, en d'autres termes dont la contrainte dépend parfaitement linéairement de la déformation. Cette disposition particulière permet d'optimiser la linéarité de la force de rappel élastique, et par conséquent de résoudre simultanément les problèmes de sensibilité aux positions et d'anisochronisme.

La demande européenne EP 3 206 089 A1, qui relève de l'article 54(3) CBE, au nom de The Swatch Group Research & Development Ltd décrit un pivot à guidage flexible 2D, c'est-à-dire réalisable dans un plan, qui peut être facilement réalisé en silicium monocristallin. Cette matière présente de nombreux avantages pour la réalisation d'un résonateur aux dimensions horlogères, en particulier d'excellentes propriétés élastiques, une mise en forme précise par technologie de photolithographie, et la possibilité de compenser thermiquement grâce à une couche d'oxydation. Le silicium a cependant le désavantage d'être fragile, donc sensible aux chocs. Ce document propose une autre géométrie, qui rend le résonateur simultanément isochrone et indépendant des positions, mais qui a l'avantage d'être réalisable en un seul niveau de silicium car toutes les lames sont dans un même plan.

Le document JP 2016 133494 A au nom de CITIZEN HOLDINGS CO LTD décrit un procédé de fabrication d'un ressort spiral de hauteur double. Le document WO 2012/010408 A1 décrit une lame flexible droite pour l'horlogerie, en matériau micro-usinable, comportant une surface supérieure et une surface inférieure parallèles, et, connexe à ladite surface supérieure, une première surface périphérique de chant en dépouille par rapport à ladite surface supérieure, sur une première hauteur.

Le document CH 709 291 A2 au nom de CSEM décrit un agencement de lames flexibles croisées, de type Wittrick, avec deux lames flexibles reliant un élément de support à un balancier, aptes à exercer un couple de rappel sur le balancier, dont une première lame est disposée dans un premier plan perpendiculaire au plan de l'oscillateur, et une deuxième lame est disposée dans un deuxième plan perpendiculaire au plan de l'oscillateur et sécant avec le premier plan, où l'axe géométrique d'oscillation de l'oscillateur est défini par l'intersection du premier plan et du deuxième plan, cet axe géométrique d'oscillation croisant les première et deuxième lames aux 7/8ême de leur longueur respective.

### Résumé de l'invention

Pour résoudre simultanément les inconvénients des pivots flexibles connus à lames en matériau micro-usinable, typiquement du silicium ou similaire, l'invention se propose d'augmenter le rapport d'aspect des lames flexibles, au moins d'un facteur multiplicatif de deux afin de :
- augmenter l'excursion angulaire maximale du pivot ;
- augmenter la résistance aux chocs du pivot ;
- améliorer la rigidité hors-plan du pivot, notamment dans la direction de l'axe de pivotement.

Les pivots à lames flexibles utilisés dans les résonateurs horlogers ont avantage à être réalisés dans un matériau dont on peut ajuster le coefficient de sensibilité thermique du module d'Young, par exemple le silicium et le quartz.

Dans le cas du silicium, les techniques d'usinage par gravure profonde permettent d'obtenir des lames ayant un rapport d'aspect RA qui est inférieur à typiquement 20, au grand maximum 30 (on définit RA = H/L où H est la hauteur de la lame dans la direction hors-plan, essentiellement selon la direction de l'axe de pivotement quand la lame est utilisée dans un pivot flexible, et L est la largeur moyenne de la lame).

Afin d'optimiser les points énoncés ci-dessus, il est avantageux d'augmenter ce rapport d'aspect. En effet, un rapport d'aspect plus élevé permet :
- d'augmenter la course angulaire maximale du pivot. En effet, il est bien connu de l'homme du métier que l'on abaisse la contrainte maximale en fabriquant des lames plus fines et plus hautes ;
- d'augmenter la résistance aux chocs du pivot. En effet, une lame plus fine et plus haute aura une section plus élevée pour une même rigidité de flexion. Ceci a pour conséquence d'augmenter la résistance à la rupture de la lame par rapport aux efforts de traction/compression qui pourraient résulter d'un choc ;
- d'améliorer la rigidité hors-plan du pivot. En effet, le rapport entre la rigidité hors plan et la rigidité dans le plan est proportionnel à RA². L'amélioration de cette rigidité peut être désirable dans certaines situations où le résonateur doit interagir avec un échappement sensible au positionnement dans la direction axiale.

A cet effet, l'invention concerne un procédé de fabrication de lame flexible droite selon la revendication 1.

L'invention concerne une lame flexible selon la revendication 7.

L'invention concerne encore un pivot flexible comportant une pluralité de telles lames flexibles.

L'invention concerne encore un résonateur d'horlogerie comportant au moins un tel pivot flexible.

L'invention concerne encore un mouvement d'horlogerie comportant au moins un tel résonateur, ou/et au moins un pivot flexible.

L'invention concerne encore une montre comportant au moins un tel résonateur, ou/et au moins un tel pivot flexible.

### Description sommaire des dessins

D'autres caractéristiques et avantages de l'invention apparaîtront à la lecture de la description détaillée qui va suivre, en référence aux dessins annexés, où :
- la figure 1 représente, de façon schématisée, et en perspective, un mécanisme résonateur d'horlogerie comportant un élément inertiel suspendu, par rapport à une structure fixe, par un ensemble de lames coplanaires effectuant à la fois son guidage et son rappel en pivotement, autour d'un axe de pivotement sur lequel est aligné le centre d'inertie de 'élément inertiel ;
- la figure 2 représente, en vue en plan, la partie centrale du mécanisme de la figure 1, avec l'axe de pivotement au croisement des directions des quatre lames alignées deux à deux ;
- la figure 3 représente, de façon schématisée en en coupe transversale, une lame en matériau micro-usinable de l'art antérieur, avec une surface périphérique en dépouille du fait du procédé de réalisation par gravure;
- les figures 4 à 10 représentent, de façon similaire à la figure 3, des sections de lames réalisées selon l'invention :

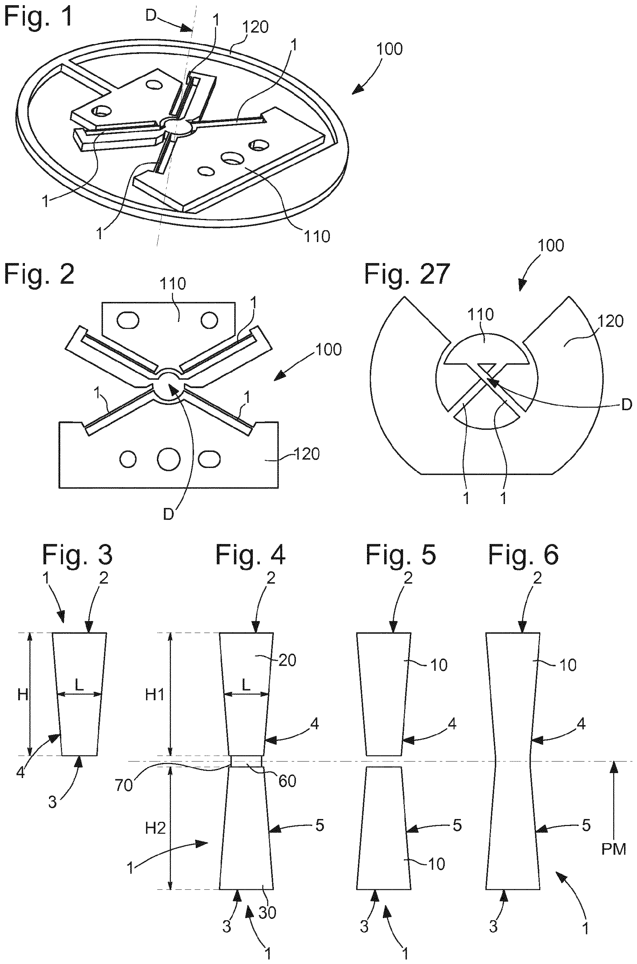

- la figure 4 illustre une lame fabriquée à partir d'une ébauche constituée de deux niveaux de silicium séparés par une couche d'oxyde (wafers SOI), la gravure de la lame étant effectuée par le haut pour le niveau supérieur, et par le bas pour le niveau inférieur ;
- la figure 5 est analogue à la figure 4, et concerne une lame dont les parties supérieure et inférieure sont réunies dans des zones continues, par exemple aux extrémités d'encastrement, et avec libération de l'oxyde, de sorte que la partie flexible des lames est séparée en deux parties alors que les encastrements restent solidaires ;
- la figure 6 concerne une lame obtenue par gravure d'un seul niveau de silicium deux fois plus épais que celui de la figure 3, l'attaque de gravure étant effectuée, comme pour les figures 4 et 5, pour moitié depuis le haut et pour moitié depuis le bas ;

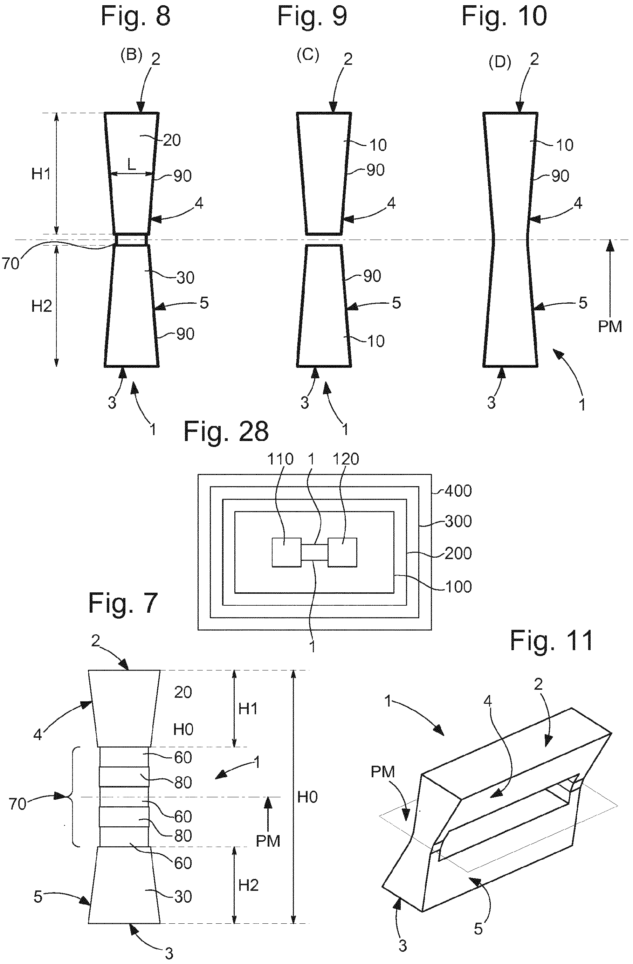

- la figure 7 illustre une variante plus complexe de lame, obtenue à partir d'un complexe réunissant plusieurs couches de silicium séparées par des couches d'oxyde de silicium ;
- les figures 8 à 10 représentent, des lames analogues à celles représentées respectivement aux figures 4 à 6, mais avec, pour réduire la sensibilité de ces lames aux variations de température, une couche superficielle d'oxyde de silicium de lames sur toute sa périphérie
- la figure 11 est une vue en perspective d'une lame selon la figure 5 ou la figure 9 ;

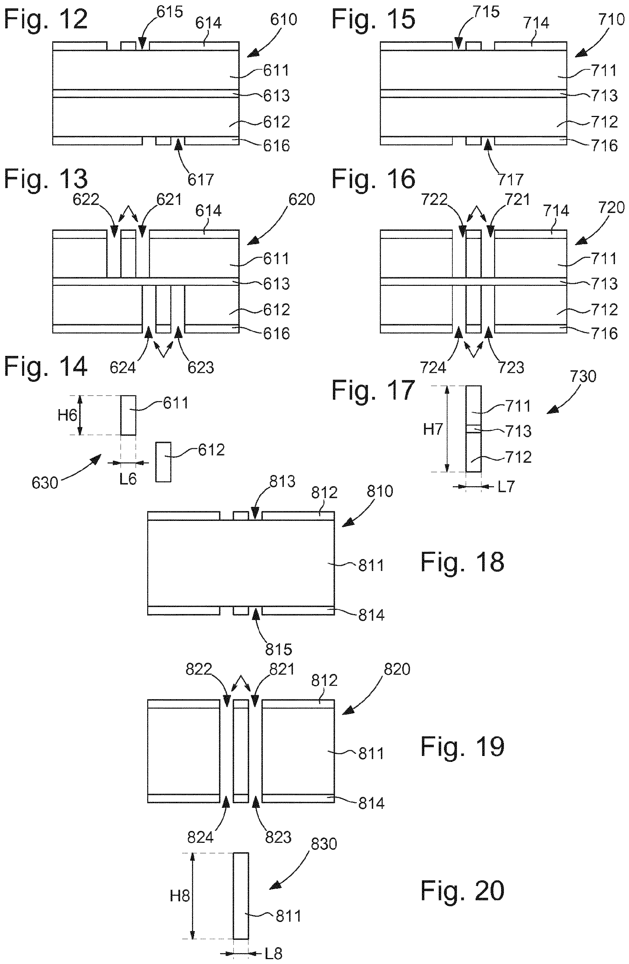

- les figures 12 à 14 illustrent, de façon schématisée, et en vue en coupe du produit en cours de réalisation, trois étapes successives de fabrication de lames flexibles, selon l'art antérieur ;
- les figures 15 à 17 illustrent, de façon similaire aux figures 12 à 14, trois étapes successives de fabrication de lames flexibles à haut rapport d'aspect, dans une première variante de procédé selon l'invention ;
- les figures 18 à 20 illustrent, de façon similaire aux figures 15 à 17, trois étapes successives de fabrication de lames flexibles à haut rapport d'aspect, dans une deuxième variante de procédé selon l'invention ;

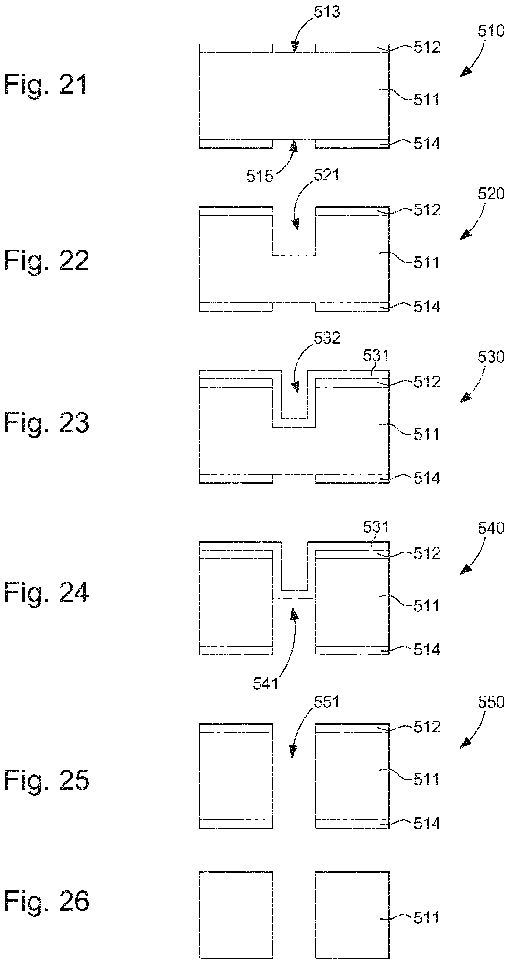

- les figures 21 à 26 illustrent, de façon similaire aux figures 15 à 17, six étapes successives de fabrication correspondant à un processus intermédiaire, dans une troisième variante de procédé selon l'invention, utilisable en combinaison avec la première variante ou la deuxième variante de procédé ;
- la figure 27 est une vue en plan d'un résonateur comportant deux telles lames, disposées dans des plans différents, et dont les projections sur l'un de ces plans se croisent au niveau de l'axe de pivotement d'un élément inertiel, dont le centre d'inertie est positionné au niveau de cet axe ;
- la figure 28 est un schéma-blocs figurant une montre comportant un mouvement d'horlogerie comportant un tel résonateur, comportant lui-même un résonateur avec un pivot flexible comportant des lames selon l'invention.

### Description détaillée des modes de réalisation préférés

L'invention concerne l'élaboration de lames flexibles droites pour mécanismes d'horlogerie, tels que pivots, résonateurs, mécanismes d'échappement, ou autres, avec des propriétés améliorées par rapport aux lames flexibles existantes. En particulier l'invention s'attache à l'obtention de lames flexibles élastiques avec un rapport d'aspect très supérieur à celui des lames de l'art antérieur.

Les lames flexibles selon l'invention doivent être utilisables aussi bien dans des structures à un seul niveau, que dans des structures plus complexes mettant en œuvre plusieurs niveaux parallèles.

La figure 1 représente un résonateur à pivot flexible en un seul niveau, comportant une structure fixe auquel est fixé un élément inertiel par l'intermédiaire d'un pivot flexible, comportant de telles lames flexibles.

L'invention est décrite ci-après pour une application simplifiée à une lame élémentaire, notamment une lame droite, et les caractéristiques de l'invention sont aussi applicables à une structure plus complexe, en particulier à un élément monobloc, notamment réalisé en matériau micro-usinable, silicium ou similaire.

La figure 2 montre un détail de la structure de la figure 1, avec un tel élément monobloc faisant en particulier pivot flexible, qui peut être réalisé en un seul niveau car toutes les lames qu'il comporte sont dans un même plan.

La figure 3 illustre une lame flexible de l'art antérieur, utilisable en particulier pour constituer un tel pivot flexible. Cette lame est fabriquée dans un seul niveau de matériau micro-usinable, notamment du silicium. De façon usuelle, cette lame 1 s'étend entre deux faces parallèles, une face supérieure 2 et une face inférieure 3, le parallélisme de ces faces est une conséquence du procédé de fabrication du matériau brut utilisé pour la fabrication de la lame, usuellement un wafer silicium, ou similaire. Une variante, non illustrée, de la lame selon l'invention peut naturellement comporter des surfaces supérieur et inférieure non parallèles, ou encore de géométrie différente. L'inclinaison des flancs de la lame 1 est propre au processus actuel de gravure profonde et n'est pas représentée à l'échelle : en effet, selon le rapport d'aspect, l'angle de dépouille devrait être de l'ordre de 1°. Le rapport d'aspect RA = H/L est limité par la technique de gravure.

L'invention consiste à réaliser une géométrie de lame flexible avec, à largeur L égale, une hauteur H très supérieure à l'existant, et en particulier mais non limitativement sur un wafer silicium à deux niveaux, dans le but d'augmenter le rapport d'aspect des lames d'un facteur deux, comme montré dans les figures 4 à 10.

Il s'agit donc d'améliorer une telle lame flexible 1 pour l'horlogerie en matériau micro-usinable, comportant une surface supérieure 2 et une surface inférieure 3 parallèles, et, connexe à la surface supérieure 2, une première surface périphérique de chant 4 en dépouille par rapport à la surface supérieure 2, sur une première hauteur H1.

A cet effet, selon l'invention, la lame flexible 1 comporte, distante de la surface supérieure 2, et connexe à la surface inférieure 3, une deuxième surface périphérique de chant 5 en contre-dépouille par rapport à la première surface périphérique de chant 4.

Cette deuxième surface périphérique de chant 5 s'étend sur une hauteur H2 ; selon l'invention H2 = H1.

Plus particulièrement, tel que visible sur les variantes des figures 6 et 10, la deuxième surface périphérique de chant 5 est connexe à la fois à la première surface périphérique de chant 4 et à la surface inférieure 3.

Plus particulièrement, tel que visible sur les variantes des figures 4, 5, 7, 8, 9, la deuxième surface périphérique de chant 5 est, au moins sur une partie de la lame flexible 1, distante de la première surface périphérique de chant 4.

Dans une première alternative de l'invention, tel que visible sur les variantes des figures 5, 6, 9, 10, la surface supérieure 2 et la surface inférieure 3 appartiennent à une même couche unique 10 de matériau micro-usinable.

Dans une deuxième alternative de l'invention, tel que visible sur les variantes des figures 4, 7, et 8, la surface supérieure 2 et la surface inférieure 3 appartiennent respectivement à une couche supérieure 20 et à une couche inférieure 30 qui sont deux couches différentes d'un même premier matériau micro-usinable entre lesquelles s'étend au moins une couche intermédiaire 60 d'un deuxième matériau micro-usinable différent du premier matériau micro-usinable.

Plus particulièrement encore, tel que visible sur les figures 4 et 7, un noyau 70 en matériau micro-usinable comportant au moins une couche 80 en matériau micro-usinable s'étend entre la couche supérieure 20 et la couche inférieure 30 ; et au moins une couche intermédiaire 60 d'un deuxième autre matériau micro-usinable s'étend à la jonction entre le noyau 70 et la couche supérieure 20 d'une part, et entre le noyau 70 et la une couche inférieure 30 d'autre part. Il est, ainsi, possible de réaliser une lame 1 multi-couches, d'épaisseur totale H0 encore bien supérieure au total H1 + H2.

Dans la réalisation particulière de la figure 4, ce noyau 70 comporte une couche 80 unique.

Dans une réalisation particulière, au moins une couche 80 est une couche du premier matériau micro-usinable.

Dans une réalisation particulière, le deuxième autre matériau micro-usinable est un oxyde du premier matériau micro-usinable. Notamment, quand le premier matériau micro-usinable est du silicium Si, le deuxième matériau micro-usinable est du dioxyde de silicium SiO₂.

Dans une réalisation particulière, illustrée par les figures 4 à 10, la première surface périphérique de chant 4 et la deuxième surface périphérique de chant 5 sont symétriques par rapport à un plan médian PM à égale distance de la surface supérieure 2 et de la surface inférieure 3.

Dans une réalisation particulière, la surface supérieure 2 et la surface inférieure 3 appartiennent chacune à une couche 10, 20, 30 d'un même premier matériau micro-usinable qui est du silicium.

Dans une réalisation particulière, la surface supérieure 2 et la surface inférieure 3 appartiennent chacune à une couche 10, 20, 30 d'un même premier matériau micro-usinable qui est du quartz.

Dans une réalisation particulière, la surface supérieure 2 et la surface inférieure 3 appartiennent chacune à une couche 10, 20, 30 d'un même premier matériau micro-usinable qui est du DLC ou du saphir ou du rubis ou du diamant.

Dans une réalisation particulière, illustrée par les figures 8 à 10, afin de rendre le mécanisme insensible aux variations de température, ce qui est essentiel dans le cas d'un résonateur, la totalité de la surface périphérique de la lame flexible 1 est la surface d'une couche mince 90 d'un oxyde d'un matériau micro-usinable dont sont constituées une couche supérieure 20 et à une couche inférieure 30 délimitées respectivement par la surface supérieure 2 et la surface inférieure 3.

L'épaisseur de la couche mince 90, notamment une couche mince d'oxyde de compensation thermique doit être adaptée de cas en cas. Plus particulièrement, dans le cas où les lames constituent le moyen de rappel élastique d'un résonateur à lames flexibles, l'épaisseur de cette couche mince 90 est ajustée finement afin que la variation de la rigidité des lames avec la température compense au mieux la variation d'inertie du résonateur avec la température (dilatation du balancier). Dans une réalisation particulière non limitative, cette épaisseur de couche mince est inférieure à 5 micromètres, plus particulièrement est comprise entre 2.5 et 5.0 micromètres; plus particulièrement encore est comprise entre 2.5 et 3.0 micromètres.

Plus particulièrement, la surface supérieure 2 et la surface inférieure 3 appartiennent chacune à une couche 10, 20, 30 d'un même premier matériau micro-usinable qui est du silicium, et la couche mince 90 est du dioxyde de silicium SiO₂.

La figure 4 illustre une variante où la lame 1 est fabriquée sur deux niveaux de silicium séparés par une couche 60 d'oxyde, notamment de dioxyde de silicium SiO₂. (wafers SOI). La gravure se fait par le haut depuis la surface supérieure 2 pour le niveau supérieur et par le bas depuis la surface inférieure 3 pour le niveau inférieur. Cette méthode permet d'atteindre un rapport d'aspect deux fois plus élevé. L'oxyde n'est pas libéré donc la lame 1 forme une seule pièce.

La figure 5 est analogue à la figure 4 mais avec libération de l'oxyde, de sorte que la partie flexible des lames est séparée en deux parties alors que les encastrements restent solidaires, tel que visible sur la figure 11. Cette variante est intéressante dans les cas où une plus grande souplesse dans la direction verticale est désirée.

La figure 6 illustre la gravure d'un seul niveau de silicium deux fois plus épais que la lame 1 de la figure 3, et l'attaque se fait pour moitié depuis la surface supérieure 2 et pour moitié depuis la surface inférieure 3.

En somme, les exécutions des figures 4 à 10 illustrent la mise en œuvre d'un même procédé, selon lequel, à partir d'un wafer en matériau micro-usinable, ou d'un empilement de wafers solidarisés par des couches d'oxyde, on effectue la gravure en partie depuis la surface supérieure 2 et en partie depuis la surface inférieure 3, pour augmenter le rapport d'aspect de la lame 1 ainsi réalisée par rapport à l'art antérieur. Plus particulièrement on effectue la gravure pour moitié depuis la surface supérieure 2 et pour moitié depuis la surface inférieure 3, pour doubler le rapport d'aspect de la lame 1 ainsi réalisée par rapport à l'art antérieur.

Comme déjà exposé ci-dessus, ce procédé peut être mis en œuvre aussi bien pour une lame isolée, que pour un élément monobloc regroupant plusieurs composants élémentaires voire plusieurs fonctions, et tout particulièrement un pivot flexible complet, ou encore un résonateur complet, ou autre.

Les figures 12 à 14 illustrent trois étapes successives de fabrication de lames flexibles, selon l'art antérieur, afin de réaliser par exemple un pivot flexible monobloc tel que représenté dans la figure 27 :
- la figure 12 expose une première étape 610 de lithographie : un premier niveau 611 est réuni à un deuxième niveau 612 par une couche intermédiaire 613 ; cet assemblage est enfermé entre un premier masque supérieur 614 plaqué sur le premier niveau 611 supérieur, et comportant des fenêtres supérieures de gravure 615, et un deuxième masque inférieur 616 plaqué sur le deuxième niveau 612 inférieur, et comportant des fenêtres inférieures de gravure 617 ; le premier masque supérieur 614 et le deuxième masque inférieur 616 ne sont ni identiques ni alignés;
- la figure 13 expose une deuxième étape 620 de gravure, lors de laquelle une gravure supérieure, pratiquée par les fenêtres supérieures de gravure 615, réalise des dégagements supérieurs 621, 622, et une gravure inférieure, pratiquée par les fenêtres inférieures de gravure 617, réalise des dégagements inférieurs 623, 624 ;
- la figure 14 expose une troisième étape de libération, lors de laquelle les masques 614 et 616 sont ôtés, et la couche intermédiaire 613 est détruite, on obtient ainsi deux lames, l'une réalisée dans le premier niveau 611, et l'autre dans le deuxième niveau 612, dans l'exemple illustré ces lames sont de section identique, et une largeur L6, et une hauteur H6, définissant un rapport d'aspect RA6 = H6/L6. Dans l'exemple considéré de la figure 27, les deux lames ainsi réalisées sont nécessairement dans deux plans distincts car elles ont des géométries distinctes.

L'invention définit un procédé permettant d'améliorer le mode opératoire de façon à obtenir l'augmentation désirée du rapport d'aspect.

Ce procédé de fabrication d'au moins une lame flexible 1 droite pour l'horlogerie en matériau micro-usinable, comportant une surface supérieure 2 et une surface inférieure 3 parallèles, comporte au moins les étapes consistant à :
- se munir d'au moins une tranche de substrat en matériau micro-usinable, comportant une face supérieure et une face inférieure parallèles ;
- constituer une plaque d'épaisseur requise par une telle tranche de substrat unique 511, 811, ou par solidarisation d'une pluralité de telles tranches de substrat 711 et 712 ;
- apposer un premier masque supérieur 512, 714, 812, comportant au moins une fenêtre supérieure 513, 715, 813, sur la face supérieure de cette plaque, et un deuxième masque inférieur 514, 716, 814, comportant au moins une fenêtre inférieure 515, 717, 815, sur la face inférieure de cette plaque ;
- graver cette plaque, à une profondeur de gravure inférieure à cette épaisseur requise, depuis un côté supérieur au niveau de chaque fenêtre supérieure 513, 715, 813, en réalisant, connexe à ladite surface supérieure 2, une première surface périphérique de chant 4 en dépouille par rapport à ladite surface supérieure 2, sur une première hauteur H1 ;
- et depuis un côté inférieur au niveau de chaque dite fenêtre inférieure 515, 717, 815, en réalisant, distante de ladite surface supérieure 2 et connexe à ladite surface inférieure 3, une deuxième surface périphérique de chant 5 en contre-dépouille par rapport à ladite première surface périphérique de chant 4 ;
- retirer le premier masque supérieur 512, 714, 812, et le deuxième masque inférieur 514, 716, 814.

Selon l'invention, ladite première surface périphérique de chant 4 et ladite deuxième surface périphérique de chant 5 sont symétriques par rapport à un plan médian PM à égale distance de ladite surface supérieure 2 et de ladite surface inférieure 3 et ce premier masque supérieur 512, 714, 812, et ce deuxième masque inférieur, respectivement 514, 716, 814, sont de géométrie identique et disposés en symétrie par rapport à un plan médian situé à mi-épaisseur de la plaque.

Et la somme des profondeurs de gravure est supérieure ou égale à l'épaisseur de la plaque, de façon à délimiter au moins une lame flexible 1 dont la hauteur H est égale à l'épaisseur de la plaque, et dont la largeur L est définie par le profil du premier masque supérieur 512, 714, 812, et du deuxième masque inférieur, respectivement 514, 716, 814. Les bords de cette lame flexible 1, autres que les faces supérieure et inférieure, sont bruts de gravure.

Pour réaliser un pivot à guidage flexible monolithique selon le procédé de l'invention décrit ci-dessus, il faut que la géométrie de ce guidage flexible soit réalisable par gravure sur un seul niveau, comme c'est le cas du pivot à guidage flexible présenté dans les figures 1 et 2. En revanche, ce n'est pas le cas du pivot à guidage flexible présenté dans la figure 27. Ce pivot de la figure 27 ne peut donc pas être réalisé de façon monolithique selon le procédé de l'invention. Toutefois, il est possible de réaliser chacune des lames (supérieure et inférieure) selon le procédé de l'invention et ensuite de réaliser le pivot de la figure 27 par assemblage de ces lames.

Dans une exécution particulière, l'étape consistant à constituer une plaque d'épaisseur requise est faite par solidarisation thermique d'une pluralité de tranches de substrat 711, 712, et constitution d'une couche intermédiaire 713, et cette couche intermédiaire 713 est conservée, dans cette au moins une lame flexible 1 fabriquée, soit en totalité, soit au moins au niveau d'un pont de jonction tel que visible sur la figure 11. Par exemple, quand le substrat est du silicium, un traitement thermique approprié permet de constituer une couche intermédiaire de dioxyde de silicium SiO₂.

Dans une autre exécution particulière, l'étape consistant à constituer une plaque d'épaisseur requise est faite par solidarisation d'une pluralité de tranches de substrat 711, 712, avec interposition d'une couche intermédiaire 713 ajoutée entre les tranches de substrat deux à deux, et la couche intermédiaire 713 est conservée dans la au moins une lame flexible 1 fabriquée, soit en totalité, soit au moins au niveau d'un pont de jonction. Par exemple des tranches de substrat peuvent être collées l'une à l'autre.

Dans un cas comme dans l'autre, la destruction, totale ou locale, de la couche intermédiaire est de préférence faite par voie chimique, par exemple avec de l'acide fluorhydrique HF dans le cas du SiO₂.

La première variante du procédé, détaillée plus loin, illustrée aux figures 15 à 17, illustre cette confection avec plusieurs tranches de substrat.

La deuxième variante, détaillée plus loin, illustrée aux figures 18 à 20, illustre cette confection avec une tranche unique de substrat.

Ces première et deuxième variantes du procédé peuvent avantageusement être complétées par une troisième variante, illustrée aux figures 21 à 26, où, lors de l'étape consistant à graver la plaque, des étapes intermédiaires sont réalisées consistant à :
- pratiquer une première gravure supérieure, par chaque fenêtre supérieure de gravure pour y réaliser un premier dégagement supérieur 521, sensiblement à mi-épaisseur de la plaque;
- appliquer une couche barrière 531 sur le premier masque supérieur, pourformer un deuxième dégagement supérieur 532 sur chaque premier dégagement supérieur 521;
- pratiquer une deuxième gravure inférieure, par chaque fenêtre inférieure de gravure pour y réaliser un dégagement inférieur 541 aligné avec le deuxième dégagement supérieur 532 et le premier dégagement supérieur 521 correspondants;
- détruire la couche barrière 531, avant de retirer le premier masque supérieur et le deuxième masque inférieur.

Plus particulièrement, on réalise cette couche barrière 531 en parylène avec une épaisseur typiquement supérieure ou égale à 10 micromètres. Toutefois une couche barrière en parylène d'épaisseur inférieure à 10 micromètres est aussi envisageable.

Dans une exécution particulière, le matériau micro-usinable du substrat est du silicium, et, après le retrait du premier masque supérieur 512, 714, 812, et du deuxième masque inférieur 514, 716, 814, on effectue sur la lame flexible 1 un traitement thermique adapté pour former une coque périphérique de SiO₂ tout autour de la lame 1 pour la rendre insensible aux variations de température, pour compenser les variations d'inertie et de longueur provoquées par la dilatation thermique. Plus particulièrement, cette épaisseur est ajustée afin que la variation de la rigidité de la lame compense la variation d'inertie de l'élément inertiel provoquée par la dilatation thermique.

Ces trois variantes de procédé sont détaillées ci-après.

Les figures 15 à 17 illustrent trois étapes successives de fabrication de lames flexibles à haut rapport d'aspect, dans une première variante de procédé selon l'invention :
- la figure 15 expose une première étape 710 de lithographie : un premier niveau 711 est réuni à un deuxième niveau 712 par une couche intermédiaire 713 ; cet assemblage est enfermé entre un premier masque supérieur 714 plaqué sur le premier niveau 711 supérieur, et comportant des fenêtres supérieures de gravure 715, et un deuxième masque inférieur 716 plaqué sur le deuxième niveau 712 inférieur, et comportant des fenêtres inférieures de gravure 717 ; le premier masque supérieur 714 et le deuxième masque inférieur 716 sont ici identiques et alignés;
- la figure 16 expose une deuxième étape 720 de gravure, lors de laquelle une gravure supérieure, pratiquée par les fenêtres supérieures de gravure 715, réalise des dégagements supérieurs 721, 722, et une gravure inférieure, pratiquée par les fenêtres inférieures de gravure 717, réalise des dégagements inférieurs 723, 724, qui sont alignés avec les dégagements supérieurs 721, 722;
- la figure 17 expose une troisième étape de libération, lors de laquelle les masques 714 et 716 sont ôtés, la couche intermédiaire 613 est conservée, on obtient ainsi une lame unique, réalisée à la fois dans le premier niveau 611, la couche intermédiaire 613, et le deuxième niveau 612, cette lame unique a une largeur L7, et une hauteur H7, définissant un rapport d'aspect RA7 = H7/L7. Si l'on part, dans la première étape 710 avec une géométrie analogue à la première étape 610 de l'art antérieur, RA7 = 2. RA6. Naturellement, le premier niveau 711 et le deuxième niveau 712, qui sont ici illustrés avec une hauteur élémentaire égale, peuvent, pour certaines applications, être de hauteur élémentaire différente.

Les figures 18 à 20 illustrent trois étapes successives de fabrication de lames flexibles à haut rapport d'aspect, dans une deuxième variante de procédé selon l'invention :
- la figure 18 expose une première étape 810 de lithographie : un niveau unique 811 est enfermé entre un premier masque supérieur 812 plaqué sur sa face supérieure, et comportant des fenêtres supérieures de gravure 813, et un deuxième masque inférieur 814 plaqué sur sa face inférieure, et comportant des fenêtres inférieures de gravure 815; le premier masque supérieur 812 et le deuxième masque inférieur 814 sont ici identiques et alignés;
- la figure 19 expose une deuxième étape 820 de gravure, lors de laquelle une gravure supérieure, pratiquée par les fenêtres supérieures de gravure 813, réalise des dégagements supérieurs 821, 822, et une gravure inférieure, pratiquée par les fenêtres inférieures de gravure 815, réalise des dégagements inférieurs 823, 824, qui sont alignés avec les dégagements supérieurs 821, 822;
- la figure 20 expose une troisième étape 830 de libération, lors de laquelle les masques 812 et 814 sont ôtés, on obtient ainsi une lame unique, réalisée dans le niveau unique 811, cette lame unique a une largeur L8, et une hauteur H8, définissant un rapport d'aspect RA8 = H8/L8. Si l'on part, dans la première étape 710 avec un niveau unique d'épaisseur équivalente au total des niveaux de la première étape 610 de l'art antérieur, RA8 = 2. RA6.

Les figures 21 à 25 illustrent six étapes successives de fabrication, correspondant à un processus intermédiaire, dans une troisième variante de procédé selon l'invention, utilisable en combinaison avec la première variante ou la deuxième variante de procédé. Ces figures ne précisent pas l'exécution de l'épaisseur des lames, exécutée selon la première variante ou la deuxième variante, mais s'attachent à montrer un procédé particulier où l'opération unique de gravure est remplacée par une séquence comportant deux opérations de gravure séparées par une opération de lithographie, et une première étape de libération :
- la figure 21 expose une première étape 510 de première lithographie : un niveau unique 511 est enfermé entre un premier masque supérieur 512 plaqué sur sa face supérieure, et comportant des fenêtres supérieures de gravure 513, et un deuxième masque inférieur 514 plaqué sur sa face inférieure, et comportant des fenêtres inférieures de gravure 515; le premier masque supérieur 512 et le deuxième masque inférieur 514 sont ici identiques et alignés;
- la figure 22 expose une deuxième étape 520 de première gravure, lors de laquelle une gravure supérieure, pratiquée par chaque fenêtre supérieure de gravure 513, y réalise un premier dégagement supérieur 521, sensiblement à mi-épaisseur du niveau unique 511;
- la figure 23 expose une troisième étape 530 de deuxième lithographie : une couche barrière 531 est appliquée sur le premier masque supérieur 512, du côté opposé au niveau unique 511, et forme un deuxième dégagement supérieur 532 sur chaque premier dégagement supérieur 521 ;
- la figure 24 expose une quatrième étape 540 de deuxième gravure, lors de laquelle une gravure inférieure, pratiquée par chaque fenêtre inférieure de gravure 515, y réalise un dégagement inférieur 541, qui est aligné avec le deuxième dégagement supérieur 532 et le premier dégagement supérieur 521 correspondants;
- la figure 25 expose une cinquième étape 550 de première libération, lors de laquelle la couche barrière 531 est détruite, avant de retirer ledit premier masque supérieur et ledit deuxième masque inférieur lors de l'étape suivante ;
- la figure 26 expose une sixième étape 550 de deuxième libération, lors de laquelle les masques 512 et 514 sont ôtés, pour l'obtention d'au moins une lame unique, réalisée dans le niveau unique 511, son rapport d'aspect RA5 dépend des formes des masques, selon le premier ou le deuxième procédé selon l'invention.

Dans une mise en œuvre particulière, les faces arrière des substrats gravés dans les équipements de gravure profonde sont refroidies, et le transfert thermique se fait par l'hélium. De ce fait, lorsque l'on fait une gravure traversante, comme dans le cas de la deuxième étape 820 de la deuxième variante de procédé, qui comporte une gravure supérieure et une gravure inférieure, il est avantageux de déposer au préalable une couche d'étanchéité, telle la couche 531 de la troisième étape 530 de deuxième lithographie dans la troisième variante décrite ci-dessus, pour éviter que l'hélium de refroidissement ne passe dans le plasma de gravure, en quel cas les caractéristiques de gravure seraient détériorées et/ou non contrôlables.

Plus particulièrement, cette couche d'étanchéité est une couche de parylène. Dans d'autres variantes, la couche d'étanchéité peut être de nature différente, comme une couche d'oxyde, de nitrure, de métal, de résine épaisse ou autre. Cette couche est enlevée après obtention de la gravure visée.

Dans le cas de la première variante, plus particulièrement la couche intermédiaire 713 est une couche d'oxyde enterré (BOX). Et, bien que la gravure s'arrête sur cette couche intermédiaire 713 qui assure en principe l'étanchéité, en pratique il est aussi avantageux de déposer une couche d'étanchéité, notamment de parylène, pour assurer qu'il n'y ait pas de fuites, par exemple si la couche d'oxyde enterré se casse. Ceci dépend des paramètres et conditions de la deuxième gravure. Avantageusement la couche d'étanchéité supplémentaire est une couche de parylène d'épaisseur supérieure ou égale à 10 micromètres.

En particulier l'invention est applicable à des résonateurs à guidage flexible en rotation tels qu'illustrés par les figures 1 et 27, ou encore à des résonateurs ayant des guidages flexibles en translation.

L'invention est applicable à d'autres matériaux élastiques usinables par gravure.

L'invention concerne un pivot flexible 100 d'horlogerie comportant au moins une telle lame flexible. Plus particulièrement ce pivot flexible 100 d'horlogerie comporte une pluralité de lames flexibles 1. Plus particulièrement ces lames flexibles 1 définissent ensemble l'axe de pivotement D du pivot flexible 100. Plus particulièrement, toutes ces lames flexibles 1 ont une section identique.

Plus particulièrement, dans la variante illustrée par la figure 27, le pivot flexible 100 comporte au moins deux lames flexibles 1 définissant ensemble, dans un même plan ou en projection sur un même plan quand elles sont parallèles et distinctes, un croisement qui définit l'axe de pivotement D du pivot flexible 100.

Plus particulièrement, le pivot flexible 100 comporte une structure fixe 110 et au moins un élément inertiel 120 reliés l'un à l'autre par les lames flexibles 1, et le centre d'inertie de l'élément inertiel 120 est aligné sur l'axe de pivotement D du pivot flexible 100.

L'invention concerne encore un résonateur 200 d'horlogerie à lames flexibles comportant de telles lames flexibles 1. Plus particulièrement ce résonateur 200 comporte au moins un tel pivot flexible 100. Plus particulièrement ses lames flexibles 1 sont agencées pour effectuer le rappel élastique de l'élément inertiel 120 vers une position neutre.

L'invention concerne encore un mouvement 300 d'horlogerie comportant au moins un tel résonateur 200, ou/et au moins un tel pivot flexible 100, ou/et comportant de telles lames flexibles 1.

L'invention concerne encore une pièce d'horlogerie, notamment une montre 400, comportant au moins un tel résonateur 200, ou/et au moins un tel pivot flexible 100 ou/et comportant de telles lames flexibles 1.

## Revendications

1. Procédé de fabrication d'au moins une lame flexible droite (1) pour l'horlogerie en matériau micro-usinable, comportant une surface supérieure (2) et une surface inférieure (3) parallèles, comportant au moins les étapes consistant à :
- se munir d'au moins une tranche de substrat en matériau micro-usinable, comportant une face supérieure et une face inférieure parallèles ;
- constituer une plaque d'épaisseur requise par une dite tranche de substrat unique (511 ; 811) ou par solidarisation d'une pluralité de dites tranches de substrat (711, 712) ;
- apposer un premier masque supérieur (512 ; 714 ; 812) comportant au moins une fenêtre supérieure (513 ; 715 ; 813) sur la face supérieure de ladite plaque, et un deuxième masque inférieur (514 ; 716 ; 814) comportant au moins une fenêtre inférieure (515 ; 717 ; 815) sur la face inférieure de ladite plaque ;
- graver ladite plaque, à une profondeur de gravure inférieure à ladite épaisseur requise, depuis un côté supérieur au niveau de chaque dite fenêtre supérieure (513 ; 715; 813), en réalisant, connexe à ladite surface supérieure (2), une première surface périphérique de chant (4) en dépouille par rapport à ladite surface supérieure (2), sur une première hauteur (H1),
- et depuis un côté inférieur au niveau de chaque dite fenêtre inférieure (515 ; 717 ; 815), en réalisant, distante de ladite surface supérieure (2) et connexe à ladite surface inférieure (3), une deuxième surface périphérique de chant (5) en contre-dépouille par rapport à ladite première surface périphérique de chant (4),
- retirer ledit premier masque supérieur (512; 714; 812) et ledit deuxième masque inférieur (514 ; 716 ; 814),
**caractérisé en ce que** ladite première surface périphérique de chant (4) et ladite deuxième surface périphérique de chant (5) sont symétriques par rapport à un plan médian (PM) à égale distance de ladite surface supérieure (2) et de ladite surface inférieure (3), et **en ce que** ledit premier masque supérieur (512 ; 714 ; 812) et ledit deuxième masque inférieur (514; 716; 814) sont de géométrie identique et disposés en symétrie par rapport à un plan médian situé à mi-épaisseur de ladite plaque, et **en ce que** la somme desdites profondeurs de gravure est supérieure ou égale à l'épaisseur de ladite plaque, de façon à délimiter au moins une lame flexible droite (1) dont la hauteur (H) est égale à l'épaisseur de ladite plaque, dont la largeur (L) est définie par le profil dudit premier masque supérieur (512 ; 714 ; 812) et dudit deuxième masque inférieur (514 ; 716 ; 814), et dont les bords sont bruts de gravure.

2. Procédé selon la revendication 1, **caractérisé en ce que** ladite étape consistant à constituer une plaque d'épaisseur requise est faite par solidarisation thermique d'une pluralité de dites tranches de substrat (711, 712), et constitution d'une couche intermédiaire (713), et **en ce que** ladite couche intermédiaire (713) est conservée, dans ladite au moins une lame flexible droite (1) fabriquée, au moins au niveau d'un pont de jonction.

3. Procédé selon la revendication 1, **caractérisé en ce que** ladite étape consistant à constituer une plaque d'épaisseur requise est faite par solidarisation d'une pluralité de dites tranches de substrat (711, 712) avec interposition d'une couche intermédiaire (713) ajoutée entre lesdites tranches de substrat deux à deux, et **en ce que** ladite couche intermédiaire (713) est conservée dans ladite au moins une lame flexible droite (1) fabriquée, au moins au niveau d'un pont de jonction.

4. Procédé selon l'une des revendications 1 à 3, **caractérisé en ce que**, lors de ladite étape consistant à graver ladite plaque, des étapes intermédiaires sont réalisées consistant à :
- pratiquer une première gravure supérieure, par chaque dite fenêtre supérieure de gravure pour y réaliser un premier dégagement supérieur (521), sensiblement à mi-épaisseur de ladite plaque;
- appliquer une couche barrière (531) sur ledit premier masque supérieur, pour former un deuxième dégagement supérieur (532) sur chaque dit premier dégagement supérieur (521) ;
- pratiquer une deuxième gravure inférieure, par chaque dite fenêtre inférieure de gravure pour y réaliser un dégagement inférieur (541) aligné avec ledit deuxième dégagement supérieur (532) et ledit premier dégagement supérieur (521) correspondants;
- détruire ladite couche barrière (531) avant de retirer ledit premier masque supérieur et ledit deuxième masque inférieur.

5. Procédé selon la revendication 4, **caractérisé en ce qu'**on réalise ladite couche barrière (531) en parylène avec une épaisseur supérieure ou égale à 10 micromètres.

6. Procédé selon l'une des revendications 1 à 5, **caractérisé en ce que** ledit matériau micro-usinable dudit substrat est du silicium, et **en ce que**, après le retrait dudit premier masque supérieur (512; 714; 812) et dudit deuxième masque inférieur (514 ; 716 ; 814), on effectue sur ladite lame flexible droite (1) un traitement thermique adapté pour former, tout autour de ladite lame (1), une coque périphérique de SiO₂ dont l'épaisseur est ajustée pour compenser les variations d'inertie et de longueur provoquées par la dilatation thermique.

7. Lame flexible (1) droite pour l'horlogerie, en matériau micro-usinable, comportant une surface supérieure (2) et une surface inférieure (3) parallèles, et, connexe à ladite surface supérieure (2), une première surface périphérique de chant (4) en dépouille par rapport à ladite surface supérieure (2), sur une première hauteur (H1), **caractérisée en ce que** ladite lame flexible (1) comporte, distante de ladite surface supérieure (2) et connexe à ladite surface inférieure (3), une deuxième surface périphérique de chant (5) en contre-dépouille par rapport à ladite première surface périphérique de chant (4), **en ce que** ladite première surface périphérique de chant (4) et ladite deuxième surface périphérique de chant (5) sont symétriques par rapport à un plan médian (PM) à égale distance de ladite surface supérieure (2) et de ladite surface inférieure (3), et **en ce que**, ou bien ladite surface supérieure (2) et ladite surface inférieure (3) appartiennent à une même couche unique (10) de dit matériau micro-usinable, ou bien ladite surface supérieure (2) et ladite surface inférieure (3) appartiennent respectivement à une couche supérieure (20) et à une couche inférieure (30) qui sont deux couches différentes d'un même premier matériau micro-usinable entre lesquelles s'étend au moins une couche intermédiaire (60) d'un deuxième matériau micro-usinable différent dudit premier matériau micro-usinable ou d'un oxyde dudit premier matériau micro-usinable

8. Lame flexible (1) selon la revendication 7, **caractérisée en ce que** ladite surface supérieure (2) et ladite surface inférieure (3) appartiennent à une même couche unique (10) de dit matériau micro-usinable, et **en ce que** ladite deuxième surface périphérique de chant (5) est connexe à la fois à ladite première surface périphérique de chant (4) et à ladite surface inférieure (3).

9. Lame flexible (1) selon la revendication 7, **caractérisée en ce que** ladite surface supérieure (2) et ladite surface inférieure (3) appartiennent à une même couche unique (10) de dit matériau micro-usinable, et **en ce que** ladite deuxième surface périphérique de chant (5) est, au moins sur une partie de ladite lame flexible (1), distante de ladite première surface périphérique de chant (4).

10. Lame flexible (1) selon l'une des revendications 7 à 9, **caractérisée en ce que** ladite surface supérieure (2) et ladite surface inférieure (3) appartiennent à une même couche unique (10) de dit matériau micro-usinable, et **en ce que** ladite même couche unique (10) de dit matériau micro-usinable est du silicium ou du quartz ou du DLC ou du saphir ou du rubis ou du diamant.

11. Lame flexible (1) selon l'une des revendications 7 à 10, **caractérisée en ce que** ladite surface supérieure (2) et ladite surface inférieure (3) appartiennent à une même couche unique (10) de dit matériau micro-usinable, et **en ce que** la totalité de la surface périphérique de ladite lame flexible (1) est la surface d'une couche mince (90) d'un oxyde d'un matériau micro-usinable dont sont constituées une couche supérieure (20) et à une couche inférieure (30) délimitées respectivement par ladite surface supérieure (2) et ladite surface inférieure (3), et **en ce que** ladite couche mince (90) a une épaisseur inférieure à 5.0 micromètres.

12. Lame flexible (1) pour l'horlogerie selon la revendication 7, **caractérisée en ce que** ladite surface supérieure (2) et ladite surface inférieure (3) appartiennent respectivement à une couche supérieure (20) et à une couche inférieure (30) qui sont deux couches différentes d'un même premier matériau micro-usinable entre lesquelles s'étend au moins une couche intermédiaire (60) d'un deuxième matériau micro-usinable différent dudit premier matériau micro-usinable ou d'un oxyde dudit premier matériau micro-usinable, et **en ce que**, entre ladite couche supérieure (20) et ladite couche inférieure (30), s'étend un noyau (70) en matériau micro-usinable comportant au moins une couche (80) en matériau micro-usinable ou constituée dudit premier matériau micro-usinable, et **en ce qu'**à chaque jonction entre ledit noyau (70) et ladite couche supérieure (20) d'une part, et entre ledit noyau (70) et ladite une couche inférieure (30) d'autre part, s'étend au moins une dite couche intermédiaire (60) d'un deuxième dit autre matériau micro-usinable.

13. Lame flexible (1) selon la revendication 12, **caractérisée en ce que** ladite surface supérieure (2) et ladite surface inférieure (3) appartiennent chacune à une couche (10 ; 20 ; 30) d'un même premier matériau micro-usinable qui est du silicium ou du quartz ou du DLC ou du saphir ou du rubis ou du diamant.

14. Lame flexible (1) selon la revendication 12 ou 13, **caractérisée en ce que** la totalité de la surface périphérique de ladite lame flexible (1) est la surface d'une couche mince (90) d'un oxyde d'un matériau micro-usinable dont sont constituées une couche supérieure (20) et à une couche inférieure (30) délimitées respectivement par ladite surface supérieure (2) et ladite surface inférieure (3), et **en ce que** ladite couche mince (90) a une épaisseur inférieure à 5.0 micromètres.

15. Pivot flexible (100) d'horlogerie comportant une pluralité de lames flexibles (1) selon l'une des revendications 7 à 14 ou réalisées par un procédé selon l'une des revendications 1 à 6, **caractérisé en ce que** lesdites lames flexibles (1) définissent ensemble l'axe de pivotement (D) dudit pivot flexible (100).

16. Pivot flexible (100) selon la revendication 15, **caractérisé en ce que** toutes lesdites lames flexibles (1) ont une section identique.

17. Pivot flexible (100) selon la revendication 15 ou 16, **caractérisé en ce que** ledit pivot flexible (100) comporte au moins deux lames flexibles (1) définissant ensemble, dans un même plan ou en projection sur un même plan quand elles sont parallèles et distinctes, un croisement qui définit ledit axe de pivotement (D) dudit pivot flexible (100).

18. Pivot flexible (100) selon l'une des revendications 15 à 17, **caractérisé en ce que** ledit pivot flexible (100) comporte une structure fixe (110) et au moins un élément inertiel (120) reliés l'un à l'autre par lesdites lames flexibles (1), et **en ce que** le centre d'inertie dudit élément inertiel (120) est aligné sur l'axe de pivotement (D) dudit pivot flexible (100).

19. Résonateur (200) d'horlogerie comportant au moins un pivot flexible (100) selon la revendication 18, **caractérisé en ce que** lesdites lames flexibles (1) sont agencées pour effectuer le rappel élastique dudit élément inertiel (120) vers une position neutre.

20. Mouvement (300) d'horlogerie comportant au moins un résonateur (200) selon la revendication 19, ou/et au moins un pivot flexible (100) selon la revendication 18.

21. Montre (400) comportant au moins un résonateur (200) selon la revendication 19, ou/et au moins un pivot flexible (100) selon la revendication18.

## Patentansprüche

1. Verfahren zur Herstellung mindestens eines geraden flexiblen Blatts (1) für den Uhrenbau aus mikrobearbeitbarem Material mit einer Oberseite (2) und einer parallelen Unterseite (3), umfassend mindestens die folgenden Schritte:
- Bereitstellen mindestens einer Substratscheibe aus mikrobearbeitbarem Material mit einer Oberseite und einer parallelen Unterseite;
- Ausbilden einer Platte mit einer gewünschten Dicke aus einer einzelnen Substratscheibe (511; 811) oder mehreren verbundenen Substratscheiben (711,712);
- Anbringen einer ersten oberen Maske (512; 714; 812), die mindestens ein oberes Fenster (513; 715; 813) auf der Oberseite der Platte aufweist und einer zweiten unteren Maske (514; 716; 814), die mindestens ein unteres Fenster (515; 717; 815) auf der Unterseite der Platte aufweist;
- Gravieren der Platte mit einer Graviertiefe, die geringer ist als die erforderliche Dicke, von einer oberen Seitenfläche bis zu jedem der oberen Fenster (513; 715; 813), unter Erstellen einer ersten Umfangskantenfläche (4), die hinterschnitten ist in Bezug auf die Oberseite (2) auf einer ersten Höhe (H1), die mit der Oberseite (2) verbunden ist,
- und von einer unteren Seitenfläche bis zu jedem unteren Fenster (515; 717; 815), durch Erstellen einer zweiten Umfangskantenfläche (5), die in Bezug auf die erste Umfangskantenfläche (4) hinterschnitten ist, mit Abstand von der Oberseite (2) und verbunden mit der Unterseite (3),
- Entfernen der ersten oberen Maske (512; 714; 812) und der zweiten unteren Maske (514; 716; 814),
**dadurch gekennzeichnet, dass** die erste Umfangskantenfläche (4) und die zweite Umfangskantenfläche (5) in Bezug auf eine gleich weit von der Oberseite (2) und der Unterseite (3) entfernte Mittelebene (PM) symmetrisch sind, und dass die erste obere Maske (512; 714; 812) und die zweite untere Maske (514; 716; 814) eine gleiche Geometrie aufweisen und in Bezug auf eine in der mittleren Dicke der Platte gelegenen Mittelebene symmetrisch angeordnet sind, und dass die Summe der Graviertiefen größer oder gleich der Dicke der Platte ist, um mindestens ein gerades flexibles Blatt (1) zu definieren, dessen Höhe (H) gleich der Dicke der Platte ist, deren Breite (L) durch das Profil der ersten oberen Maske (512; 714; 812) und der zweiten unteren Maske (514; 716; 814) festgelegt wird und deren Kanten rau graviert sind.

2. Verfahren nach Anspruch 1, **dadurch gekennzeichnet, dass** der Schritt zum Ausbilden einer Platte der gewünschten Dicke durch thermische Verbindung mehrerer Substratscheiben (711, 712)und Ausbilden einer Zwischenschicht (713) erfolgt, und dass die Zwischenschicht (713) in dem mindestens einen hergestellten geraden flexiblen Blatt (1), zumindest an einer Verbindungsbrücke erhalten bleibt.

3. Verfahren nach Anspruch 1, **dadurch gekennzeichnet, dass** der Schritt zum Ausbilden einer Platte der erforderlichen Dicke durch Verbindung mehrerer Substratscheiben (711, 712) unter Zwischenlegen einer Zwischenschicht (713) erfolgt, die paarweise zwischen die Substratscheiben eingefügt wird, und dass die Zwischenschicht (713) in dem mindestens einen hergestellten geraden flexiblen Blatt (1) zumindest an einer Verbindungsbrücke erhalten bleibt.

4. Verfahren nach einem der Ansprüche 1 bis 3, **dadurch gekennzeichnet, dass** bei dem Schritt zum Gravieren der Platte folgende Zwischenschritte ausgeführt werden:
- Durchführen einer ersten oberen Gravur durch jedes obere Gravurfenster, um einen ersten oberen Freiraum (521) im Wesentlichen in der Mitte der Dicke der Platte herzustellen;
- Aufbringen einer Sperrschicht (531) auf die erste obere Maske, um einen zweiten oberen Freiraum (532) auf jedem ersten oberen Freiraum (521) zu bilden;
- Durchführen einer zweiten unteren Gravur durch jedes untere Gravurfenster, um einen unteren Freiraum (541) bereitzustellen, der mit dem entsprechenden zweiten oberen Freiraum (532) und dem entsprechenden ersten oberen Freiraum (521) ausgerichtet ist;
- Zerstören der Sperrschicht (531) vor dem Abnehmen der ersten oberen Maske und der zweiten unteren Maske.

5. Verfahren nach Anspruch 4, **dadurch gekennzeichnet, dass** die Sperrschicht (531) aus Parylen mit einer Dicke von 10 µm oder mehr besteht.

6. Verfahren nach einem der Ansprüche 1 bis 5, **dadurch gekennzeichnet, dass** das mikrobearbeitbare Material des Substrats Silizium ist und dass nach dem Abnehmen der ersten oberen Maske (512; 714; 812) und der zweiten unteren Maske (514; 716; 814) an dem rechten flexiblen Blatt (1) eine geeignete Wärmebehandlung durchgeführt wird, um rings um das Blatt (1) eine Ummantelung aus SiO₂ zu bilden, deren Dicke angepasst wird, um durch Wärmeausdehnung verursachte Schwankungen in Trägheit und Länge auszugleichen.

7. Gerades flexibles Blatt (1) für den Uhrenbau aus mikrobearbeitbarem Material, mit einer Oberseite (2) und einer parallelen Unterseite (3), und, verbunden mit der Oberseite (2), einer ersten Umfangskantenfläche (4), die hinterschnitten ist in Bezug auf die Oberseite (2) auf einer ersten Höhe (H1), **dadurch gekennzeichnet, dass** das flexible Blatt (1) mit Abstand zur Oberseite (2) und verbunden mit der Unterseite (3) eine zweite hinterschnittene Umfangskantenfläche (5) in Bezug auf die erste Umfangskantenfläche (4) aufweist, dass die erste Umfangskantenfläche (4) und die zweite Umfangskantenfläche (5) in Bezug auf eine gleich weit von der Oberseite (2) und der Unterseite (3) entfernte Mittelebene (PM) symmetrisch sind, und dass entweder die Oberseite (2) und die Unterseite (3) zu derselben einzelnen Schicht (10) des mikrobearbeitbaren Materials gehören, oder die Oberseite (2) und die Unterseite (3) jeweils zu einer oberen Schicht (20) und einer unteren Schicht (30) gehören, die zwei verschiedene Schichten desselben ersten mikrobearbeitbaren Materials sind, zwischen denen sich mindestens eine Zwischenschicht (60) aus einem zweiten mikrobearbeitbaren Material, das sich von dem ersten mikrobearbeitbaren Material unterscheidet, oder aus einem Oxid des ersten mikrobearbeitbaren Materials erstreckt.

8. Flexibles Blatt (1) nach Anspruch 7, **dadurch gekennzeichnet, dass** die Oberseite (2) und die Unterseite (3) zur gleichen einzelnen Schicht (10) des mikrobearbeitbaren Materials gehören und dass die zweite Umfangskantenfläche (5) sowohl mit der ersten Umfangskantenfläche (4) als auch mit der Unterseite (3) verbunden ist.

9. Flexibles Blatt (1) nach Anspruch 7, **dadurch gekennzeichnet, dass** die Oberseite (2) und die Unterseite (3) zur gleichen einzelnen Schicht (10) des mikrobearbeitbaren Materials gehören und dass die zweite Umfangskantenfläche (5) zumindest auf einem Abschnitt des flexiblen Blatts (1) von der ersten Umfangskantenfläche (4) beabstandet ist.

10. Flexibles Blatt (1) nach einem der Ansprüche 7 bis 9, **dadurch gekennzeichnet, dass** die Oberseite (2) und die Unterseite (3) zur gleichen einzelnen Schicht (10) des mikrobearbeitbaren Materials gehören und dass die gleiche einzelne Schicht (10) des mikrobearbeitbaren Materials aus Silizium oder Quarz oder DLC oder Saphir oder Rubin oder Diamant hergestellt ist.

11. Flexibles Blatt (1) nach einem der Ansprüche 7 bis 10, **dadurch gekennzeichnet, dass** die Oberseite (2) und die Unterseite (3) zur gleichen einzelnen Schicht (10) des mikrobearbeitbaren Materials gehören und dass die gesamte Umfangsfläche des flexiblen Blatts (1) die Oberfläche einer dünnen Schicht (90) aus einem Oxid eines mikrobearbeitbaren Materials ist, von der eine obere Schicht (20) und eine untere Schicht (30) jeweils durch die Oberseite (2) und die Unterseite (3) begrenzt sind, und dass die dünne Schicht (90) eine Dicke von weniger als 5,0 µm aufweist.

12. Flexibles Blatt (1) für die Uhrenherstellung nach Anspruch 7, **dadurch gekennzeichnet, dass** die Oberseite (2) und die Unterseite (3) zu einer oberen Schicht (20) bzw. zu einer unteren Schicht (30) gehören, die zwei verschiedene Schichten desselben ersten mikrobearbeitbaren Materials sind, zwischen denen sich mindestens eine Zwischenschicht (60) aus einem zweiten mikrobearbeitbaren Material erstreckt, das sich von dem ersten mikrobearbeitbaren Material oder einem Oxid des ersten mikrobearbeitbaren Materials unterscheidet, und dass sich zwischen der oberen Schicht (20) und der unteren Schicht (30) ein Kern (70) aus mikrobearbeitbarem Material erstreckt, der mindestens eine Schicht (80) aus mikrobearbeitbarem Material umfasst oder aus dem ersten mikrobearbeitbaren Material besteht, und dass sich an jeder Verbindungsstelle zwischen dem Kern (70) und der oberen Schicht (20) einerseits und zwischen dem Kern (70) und der unteren Schicht (30) andererseits mindestens eine Zwischenschicht (60) aus einem zweiten anderen mikrobearbeitbaren Material erstreckt.

13. Flexibles Blatt (1) nach Anspruch 12, **dadurch gekennzeichnet, dass** die Oberseite (2) und die Unterseite (3) jeweils zu einer Schicht (10; 20; 30) eines gleichen ersten mikrobearbeitbaren Materials gehören, das aus Silizium oder Quarz oder DLC oder Saphir oder Rubin oder Diamant hergestellt ist.

14. Flexibles Blatt (1) nach Anspruch 12 oder 13, **dadurch gekennzeichnet, dass** die gesamte Umfangsfläche des flexiblen Blatts (1) die Oberfläche einer dünnen Schicht (90) aus einem Oxid eines mikrobearbeitbaren Materials ist, von der eine obere Schicht (20) und eine untere Schicht (30) jeweils durch die Oberseite (2) und die Unterseite (3) begrenzt sind, und dass die dünne Schicht (90) eine Dicke von weniger als 5,0 Mikrometern aufweist.

15. Flexibler Uhrendrehzapfen (100) mit mehreren flexiblen Blättern (1) nach einem der Ansprüche 7 bis 14 oder hergestellt durch ein Verfahren nach einem der Ansprüche 1 bis 6, **dadurch gekennzeichnet, dass** diese flexiblen Blätter (1) zusammen die Schwenkachse (D) des flexiblen Drehzapfens (100) festlegen.

16. Flexibler Drehzapfen (100) nach Anspruch 15, **dadurch gekennzeichnet, dass** sämtliche flexiblen Blätter (1) einen identischen Querschnitt aufweisen.

17. Flexibler Drehzapfen (100) nach Anspruch 15 oder 16, **dadurch gekennzeichnet, dass** der flexible Drehzapfen (100) mindestens zwei flexible Blätter (1) umfasst, die zusammen in der gleichen Ebene oder projiziert auf die gleiche Ebene, wenn sie parallel und verschieden sind, einen Schnittpunkt festlegen, der die Schwenkachse (D) des flexiblen Drehzapfens (100) definiert.

18. Flexibler Drehzapfen (100) nach einem der Ansprüche 15 bis 17, **dadurch gekennzeichnet, dass** der flexible Drehzapfen (100) eine feste Struktur (110) und mindestens ein Trägheitselement (120) umfasst, das durch die flexiblen Blätter (1) miteinander verbunden ist, und dass der Trägheitsmittelpunkt des Trägheitselements (120) mit der Schwenkachse (D) des flexiblen Drehzapfens (100) ausgerichtet ist.

19. Uhrenresonator (200) mit mindestens einem flexiblen Drehzapfen (100) nach Anspruch 18, **dadurch gekennzeichnet, dass** die flexiblen Blätter (1) angeordnet sind, um die elastische Rückstellung des Trägheitselements (120) in eine neutrale Position zu bewirken.

20. Uhrwerk (300) mit mindestens einem Resonator (200) nach Anspruch 19 und/oder mindestens einem flexiblen Drehzapfen (100) nach Anspruch 18.

21. Uhr (400) mit mindestens einem Resonator (200) nach Anspruch 19 und/oder mindestens einem flexiblen Drehzapfen (100) nach Anspruch 18.

## Claims

1. Method for manufacturing at least one straight flexible strip (1) for horology made of micromachinable material, comprising an upper surface (2) and lower surface (3) which are parallel, including at least the steps consisting of:
- taking at least one substrate wafer made of micromachinable material, including an upper face and lower face which are parallel;
- forming a plate of the required thickness with a single said substrate wafer (511; 811), or by joining a plurality of said substrate wafers (711; 712);
- affixing a first, upper mask (512; 714; 812) including at least one upper window (513; 715; 813) on the upper face of said plate, and a second, lower mask (514; 716; 814) including at least one lower window (515; 717; 815) on the lower face of said plate;
- etching said plate, to a lower etch depth than said required thickness, from an upper side at each said upper window (513; 715; 813), creating, adjacent to said upper surface (2), a first peripheral edge surface (4) tapered with respect to said upper surface (2), over a first height (H1),
- and creating, from a lower side at each said lower window (515; 717; 815), remote from said upper surface (2) and adjacent to said lower surface (3), a second peripheral edge surface (5) reverse-tapered with respect to said first peripheral edge surface (4);
- removing said first, upper mask (512; 714; 812) and said second, lower mask (514; 716; 814),
**characterized in that** said first peripheral edge surface (4) and said second peripheral edge surface (5) are symmetrical with respect to a median plane (PM) equidistant from said upper surface (2) and from said lower surface (3), and **in that** said first, upper mask (512; 714; 812) and said second, lower mask (514; 716; 814) are of identical geometry and disposed in symmetry with respect to a median plane located at mid-thickness of said plate, and **in that** the sum of said etch depths is greater than or equal to the thickness of said plate, so as to delimit at least one straight flexible strip (1) whose height (H) is equal to the thickness of said plate, whose width (L) is defined by the profile of said first, upper mask (512; 714; 812) and said second, lower mask (514; 716; 814), and whose edges are as-etched.

2. Method according to claim 1, **characterized in that** said step consisting of forming a plate of the required thickness is achieved by thermal bonding a plurality of said substrate wafers (711, 712), and forming an intermediate layer (713), and **in that** said intermediate layer (713) is kept, in said at least one manufactured straight flexible strip (1), at least at a junction bridge.

3. Method according to claim 1, **characterized in that** said step consisting of forming a plate of the required thickness is achieved by joining a plurality of said substrate wafers (711, 712), with the insertion of an intermediate layer (713) added between pairs of said substrate wafers, and **in that** said intermediate layer (713) is kept in said at least one manufactured straight flexible strip (1), at least at a junction bridge.

4. Method according to any of claims 1 to 3, **characterized in that**, during said step consisting in etching said plate, intermediate steps are performed, consisting of:
- performing a first, upper etch, through each said upper etching window to form a first upper recess (521) therein, substantially at mid-thickness of said plate;
- applying a barrier layer (531) onto said first, upper mask, to form a second upper recess (532) on each said first upper recess (521);
- performing a second, lower etch, through each said lower etching window to form therein a lower recess (541) aligned with said corresponding second upper recess (532) and first upper recess (521);
- destroying said barrier layer (531), prior to removing said first, upper mask and said second, lower mask.

5. Method according to claim 4, **characterized in that** said barrier layer (531) is made of parylene with a thickness greater than or equal to 10 micrometers.

6. Method according to any of claims 1 to 5, **characterized in that** said micromachinable material of said substrate is silicon, and **in that**, after the removal of said first, upper mask (512; 714; 812) and of said second, lower mask (514; 716; 814), there is performed on said straight flexible strip (1) a heat treatment adapted to form, all around said strip (1), a peripheral shell of SiO₂ whose thickness is adjusted to compensate for variations of inertia and of length caused by thermal expansion.

7. Straight flexible strip (1) for horology made of micromachinable material, comprising an upper surface (2) and lower surface (3) which are parallel, and, adjacent to said upper surface (2), a first peripheral edge surface (4) tapered with respect to said upper surface (2), over a first height (H1), **characterized in that** said flexible strip (1) comprises, remote from said upper surface (2) and adjacent to said lower surface (3), a second peripheral edge surface (5) reverse-tapered with respect to said first peripheral edge surface (4), **in that** said first peripheral edge surface (4) and said second peripheral edge surface (5) are symmetrical with respect to a median plane (PM) equidistant from said upper surface (2) and from said lower surface (3), and **in that** either said upper surface (2) and said lower surface (3) form part of the same single layer (10) of said micromachinable material, or said upper surface (2) and said lower surface (3) are respectively part of an upper layer (20) and a lower layer (30) which are two different layers of the same first micromachinable material between which extends at least one intermediate layer (60) of a second micromachinable material, different from said first micromachinable material, or of an oxide of said first micromachinable material.

8. Flexible strip (1) according to claim 7, **characterized in that** said upper surface (2) and said lower surface (3) form part of the same single layer (10) of said micromachinable material, and **in that** said second peripheral edge surface (5) is adjacent both to said first peripheral edge surface (4) and to said lower surface (3).

9. Flexible strip (1) according to claim 7, **characterized in that** said upper surface (2) and said lower surface (3) form part of the same single layer (10) of said micromachinable material, and **in that** said second peripheral edge surface (5) is, at least on one part of said flexible strip (1), remote from said first peripheral edge surface (4).

10. Flexible strip (1) according to any of claims 7 to 9, **characterized in that** said upper surface (2) and said lower surface (3) form part of the same single layer (10) of said micromachinable material, and **in that** said same single layer (10) of said micromachinable material is silicon or quartz or DLC or sapphire or ruby or diamond.

11. Flexible strip (1) according to any of claims 7 to 10, **characterized in that** said upper surface (2) and said lower surface (3) form part of the same single layer (10) of said micromachinable material, and **in that** the entire peripheral surface of said flexible strip (1) is the surface of a thin layer (90) of an oxide of a micromachinable material of which are formed an upper layer (20) and a lower layer (30) respectively delimited by said upper surface (2) and said lower surface (3), and **in that** said thin layer (90) has a thickness of less than 5.0 micrometers.

12. Flexible strip (1) for horology according to claim 7, **characterized in that** said upper surface (2) and said lower surface (3) are respectively part of an upper layer (20) and a lower layer (30) which are two different layers of the same first micromachinable material between which extends at least one intermediate layer (60) of a second micromachinable material, different from said first micromachinable material, or of an oxide of said first micromachinable material, and **in that**, between said upper layer (20) and said lower layer (30), extends a core (70) made of micromachinable material comprising at least one layer (80) made of micromachinable material or formed of said first micromachinable material, and **in that**, at each junction between said core (70) and said upper layer (20) on the one hand, and between said core (70) and said one lower layer (30) on the other hand, extends at least one said intermediate layer (60) of a second said different micromachinable material.

13. Flexible strip (1) according to claim 12, **characterized in that** said upper surface (2) and said lower surface (3) are each part of a layer (10; 20; 30) of the same first micromachinable material which is silicon or quartz or DLC or sapphire or ruby or diamond.

14. Flexible strip (1) according to claim 12 or 13, **characterized in that** the entire peripheral surface of said flexible strip (1) is the surface of a thin layer (90) of an oxide of a micromachinable material of which are formed an upper layer (20) and a lower layer (30) respectively delimited by said upper surface (2) and said lower surface (3), and **in that** said thin layer (90) has a thickness of less than 5.0 micrometers.

15. Flexible pivot (100) for horology comprising a plurality of flexible strips (1) according to any of claims 7 to 14 or produced by a method according to any of claims 1 to 6, **characterized in that** said flexible strips (1) together define the axis of pivoting (D) of said flexible pivot (100).

16. Flexible pivot (100) according to claim 15, **characterized in that** said flexible strips (1) all have an identical cross-section.

17. Flexible pivot (100) according to claim 15 or 16, **characterized in that** said flexible pivot (100) includes at least two flexible strips (1) together defining, in the same plane or in projection onto the same plane when said strips are parallel and distinct, a crossing point which defines said axis of pivoting (D) of said flexible pivot (100).

18. Flexible pivot (100) according to any of claims 15 to 17, **characterized in that** said flexible pivot (100) includes a fixed structure (110) and at least one inertial element (120) connected to each other by said flexible strips (1), and **in that** the center of inertia of said inertial element (120) is aligned on the axis of pivoting (D) of said flexible pivot (100).

19. Timepiece resonator (200) comprising at least one flexible pivot (100) according to claim 18, **characterized in that** said flexible strips (1) are arranged to elastically return said inertial element (120) to a neutral position.

20. Timepiece movement (300) including at least one resonator (200) according to claim 19, and/or at least one flexible pivot (100) according to claim 18.

21. Watch (400) comprising at least one resonator (200) according to claim 19, and/or at least one flexible pivot (100) according to claim 18.
